# EUROPEAN PATENT APPLICATION

(11) **EP 0 986 171 A1**
(43) Date of publication of application: **15.03.2000**
(21) Application number: 99116627.3
(22) Date of filing: 25.08.1999
(51) Int. Cl.: H03F 3/72, H03F 1/02

(54) **Transmitting apparatus and transmitting method**

(30) Priority: 01.09.1998 JP 24722598
(71) Applicant: MATSUSHITA ELECTRIC INDUSTRIAL CO., LTD., Kadoma-shi, Osaka 571-8501 (JP)
(72) Inventor: Yamaguchi, Manabu, Yokohama-shi, Kanagawa 233-0008 (JP); Obara, Toshio, Yokohama-shi, Kanagawa 240-0026 (JP)
(74) Representative: Grünecker, Kinkeldey, Stockmair & Schwanhäusser Anwaltssozietät

(57) **Abstract**

At an amplifying time, a first switching circuit 103 is controlled so that an input signal is amplified by a power amplifier 102, thereafter the input signal is output to a circulator 106, and a second switching circuit 104 is controlled so that the circulator 106 is terminated by a fixed resistor 111 in accordance with circuit's characteristic impedance. Also, at a non-amplifying time, the first switching circuit 103 and the second switching circuit 104 are controlled so that the input signal is output to the circulator 106, and a third switching circuit 105 is controlled so that drain power 109 of the power amplifier 102 and gate power 110 thereof are switched off. This makes it possible to carry out bypass control of the power amplifier without increasing a circuit current.

## Description

### BACKGROUND OF THE INVENTION

### Field of the Invention

The present invention relates to a transmitting apparatus for carrying out transmission power control for use in a digital mobile communication, etc., and relates to a transmitting method. Particularly, the present invention relates to a transmitting apparatus for carrying out transmission power control for use in a CDMA (Code Division Multiple Access) mobile communication, etc., and relates to a transmitting method.

### Description of the Related Art

In Japanese Patent Application Unexamined Publication No. HEI 7-170202 and Japanese Patent Application Unexamined Publication No. HEI 9-46152, there is described a conventional transmitting apparatus.

In CDMA communication, which is carried out in a digital mobile communication, a sender secondary modulates a primary modulated signal by a spread signal and transmits it to a receiver. Then, the receiver performs correlation between the transmitted signal and a spread signal of a desired channel, namely, the receiver performs despreading so as to extract a target primary modulation wave. In the process of the despreading, a signal of the other channel becomes noise.

In a forward link from a base station to a mobile station, a target signal wave and the other interference wave are subjected to variations on a propagation path in the same way and reach each mobile station. For this reason, the relationship between the signal wave and the interference wave in the reception level after despreading becomes constant.

However, in a reverse link from the mobile station to the base station, even if the respective mobile stations transmit the signal waves using the same transmission power, the reception level of each signal wave at the base station differs since the respective mobile stations are different from each other in the distance between the mobile station and the base station and propagation environment.

In order to demodulate the respective signal waves correctly by despreading in the base station, transmission power of each station must be controlled such that the reception levels of the respective signal waves in the base station are the same, and transmission power control having a high accuracy and a wide dynamic range is required in the mobile stations.

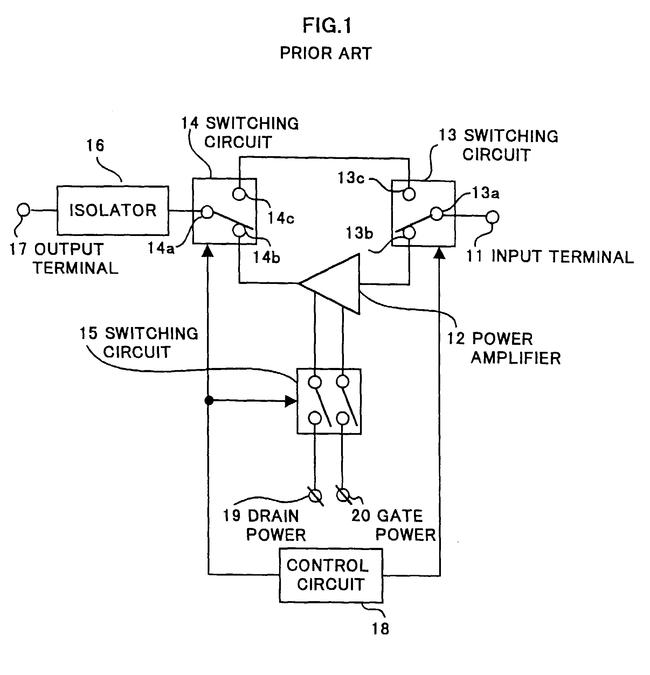

FIG. 1 is a block diagram showing the structure of the conventional transmitting apparatus in which transmission power control for use in the digital mobile communication is carried out.

In FIG. 1, reference numeral 11 denotes an input terminal, 12: a power amplifier, 13: a first switching circuit, 14: a second switching circuit, 15: a third switching circuit, 16: an isolator, 17: an output terminal, 18: a control circuit, 19: drain power, and 20: gate power.

In a case where the power amplifier 12 is used in the transmitting apparatus of FIG. 1, the control circuit 18 electrically connects the terminal 13a of the first switching circuit 13 to the terminal 13b thereof by use of a control signal. Also, the control circuit 18 electrically connects the terminal 14a of the second switching circuit 14 to the terminal 14b thereof, and further turns on the third switching circuit 15 so as to supply power to the power amplifier 12 from drain power 19 and gate power 20.

As a result, the signal input from the input terminal 11 is output to the power amplifier 12 through the switching circuit 13, and amplified by the power amplifier 12. Thereafter, the amplified signal is input to the isolator 16 through the second switching circuit 14, and output to the output terminal 17.

In a case where the power amplifier 12 is bypassed, the control circuit 18 electrically connects the terminal 13a of the first switching circuit 13 to the terminal 13c thereof by use of the control signal. Also, the control circuit 18 electrically connects the terminal 14a of the second switching circuit 14 to the terminal 14c thereof, and further turns on the third switching circuit 15 so as to prevent drain power 19 and gate power 20 from being supplied to the power amplifier 12.

As a result, the signal input from the input terminal 11 is input to the isolator 16 through the switching circuit 13 and the second switching circuit 14, and output to the output terminal 17. In other words, power of the power amplifier 12 is turned off and bypassed, so that a circuit current generated at the time of a low transmission output is reduced.

However, in the conventional apparatus, the switching circuit 14 is inserted to the output side of the power amplifier 12. For this reason, when the transmission is carried out using the power amplifier 12, there occurs a problem in which an output current of the power amplifier 12 increases power loss of the second switching circuit 14, with the result that the circuit current is increased.

### SUMMARY OF THE INVENTION

An object of the present invention is to provide a transmitting apparatus, which carries out bypass control of a power amplifier without increasing a circuit current so that high efficiency of the transmitting apparatus can be realized, and to provide a transmitting method.

According to the present invention, a switching circuit for switching an output of a power amplifier and a bypass line is formed of a circulator, the circulator is used as an isolator at the time of using the power amplifier so as to reduce power loss due to the switching circuit, whereby attaining the above-mentioned object.

### BRIEF DESCRIPTION OF THE DRAWINGS

The above and other objects and features of the invention will appear more fully hereinafter from a consideration of the following description taken in connection with the accompanying drawing wherein one example is illustrated by way of example, in which;
FIG. 1 is a block diagram showing the structure of a conventional transmitting apparatus;
FIG. 2 is a block diagram showing the structure of a transmitting apparatus according to a first embodiment of the present invention;
FIG. 3 is a block diagram showing the structure of a transmitting apparatus according to a second embodiment of the present invention;
FIG. 4 is a block diagram showing the structure of a transmitting apparatus according to a third embodiment of the present invention;
FIG. 5 is a block diagram showing the structure of a transmitting apparatus according to a fourth embodiment of the present invention;
FIG. 6 is a block diagram showing the structure of a transmitter according to a fifth embodiment of the present invention;
FIG. 7 is a block diagram showing the structure of a transmitter according to a sixth embodiment of the present invention;
FIG. 8 is a block diagram showing the structure of a transmitter according to a seventh embodiment of the present invention; and
FIG. 9 is a block diagram showing the structure of a transmitter according to an eighth embodiment of the present invention.

### DETAILED DESCRIPTION OF THE PREFERRED EMBODIMENTS

Embodiments of the present invention will now be specifically described with reference to the accompanying drawings.

### (First embodiment)

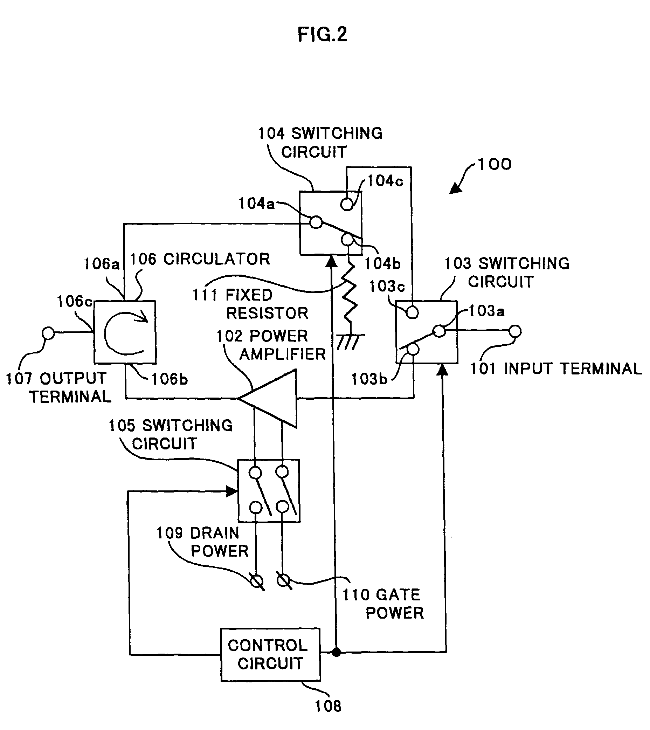

FIG. 2 is a block diagram showing the structure of a transmitting apparatus according to a first embodiment of the present invention.

In a transmitting apparatus 100 shown in FIG. 2, reference numeral 101 is an input terminal, 102: a power amplifier, 103: a first switching circuit, 104: a second switching circuit, 105: a third switching circuit, 106: a circulator, 107: an output terminal, 108: a control circuit, 109: drain power, 110: gate power, and 111: a fixed resistor.

The first switching circuit 103 is a switch for transmitting signals input from the input terminal 101 to either a path where the signals are passed through the power amplifier 102 or a path where the signals are not passed therethrough in accordance with a control signal of the control circuit 108.

The power amplifier 102 power amplifies a signal output from the terminal 103b of the first switching circuit 103.

The second switching circuit 104 switches on/off the output signal of the terminal 103c of the first switching circuit 103 and the fixed resistor 111 grounded in accordance with the control signal of the control circuit 108.

The circulator 106 circulates an output of the second switching circuit 104 and that of the power amplifier 102.

The third switching circuit 105 turns on/off the output terminal 107 for outputting an output signal of the circulator 106, drain power 109 of the power amplifier 102 and gate power 110 in accordance with the control signal of the control circuit 108.

The control circuit 108 generates the control signal for controlling the first switching circuit 103, second switching circuit 104, and the third switching circuit 105.

The following will explain an operation of the above-structured transmitting apparatus 100. First of all, an operation to be performed when the power amplifier 102 is used will be explained.

In the first switching circuit 103, a terminal 103a and a terminal 103b are electrically connected to each other by the control signal of the control circuit 108. Then, a signal, which is input from the input terminal 101, is output to the power amplifier 102 from the terminal 103a of the first switching circuit 103 through the terminal 103b, and amplified by the power amplifier 102. Thereafter, the amplified signal is input to a terminal 106b of the circulator 106.

At this time, in the second switching circuit 104, a terminal 104a and a terminal 104b are electrically connected to each other by the control signal of the control circuit 108. Then, the terminal 106a of the circulator 106 is terminated by the fixed resistor 111 in accordance with the circuit's characteristic impedance.

At the same time, the third switching circuit 105 is turned on by the control signal of the control circuit 108, so that power is supplied to the power amplifier 102 from drain power 109 and gate power 110.

Here, the circulator 106 whose terminal 106a is terminated at the circuit's characteristic impedance is the same as an isolator having directivity toward the terminal 106c from the terminal 106b. In this case, the output signal of the power amplifier 102 is output to the output terminal 107 from the terminal 106c of the circulator 106.

Next, an operation to be performed when the power amplifier 102 is bypassed will be explained.

In the first switching circuit 103, the terminal 103a and a terminal 103c are electrically connected to each other by the control signal of the control circuit 108. Also, in the second switching circuit 104, the terminal 104c and a terminal 104a are electrically connected to each other by the control signal of the control circuit 108.

Then, the signal, which is input from the input terminal 101, is input to the terminal 103c from the terminal 103a of the first switching circuit 103, and further input to the terminal 106a of the circulator 106 from the terminal 104c of the second circuit 104 through a bypass line of the terminal 104a.

At this time, in the third switching circuit 105, drain power 109 and gate power 110 are turned off, so that power of the power amplifier 102 is turned off.

When the power amplifier 102 is turned off, the circulator 106 outputs a signal in a direction of rotation of the terminal 106c from the terminal 106a.

Thus, according to the transmitting apparatus of the first embodiment, the power amplifier 102 is turned on/off in accordance with the transmitting output level, and the transmission path for transmitting signals can be switched. Then, in a case where the power amplifier 102 is used, the circulator 106 can be used as an isolator.

This eliminates the need for using the structure in which the switching circuit is connected just after the power amplifier unlike prior art, so that power loss due to the switching circuit can be reduced. Also, at a low transmission power time, the power amplifier 102 is bypassed through the bypass line so as to turn off power of the power amplifier 102, with the result that the circuit current can be reduced.

### (Second embodiment)

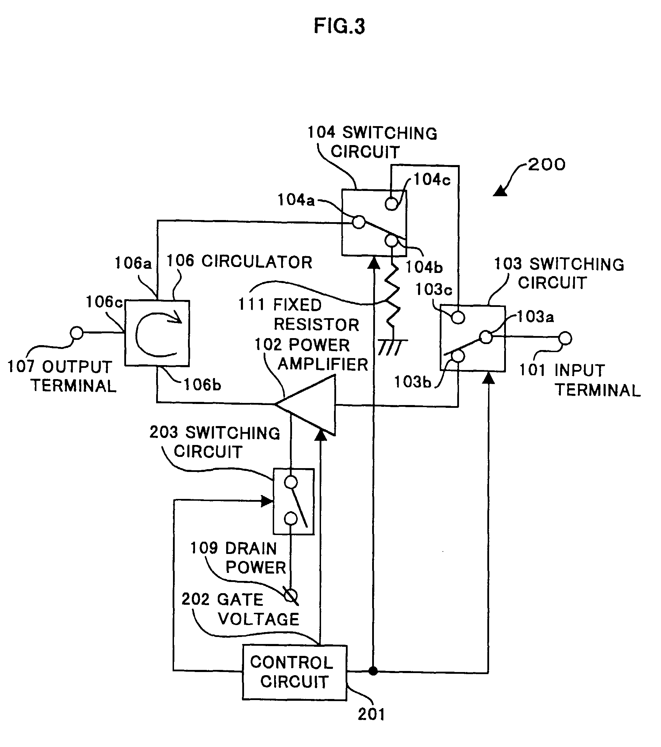

FIG. 3 is a block diagram showing the structure of a transmitting apparatus according to a second embodiment of the present invention. In this case, the same reference numerals are added to the portions common to the first embodiment of FIG. 2, and the explanation will be omitted.

The difference between a transmitting apparatus 200 of the second embodiment shown in FIG. 3 and the transmitting apparatus of the first embodiment lies in that a gate voltage 202 of the power amplifier 102 is controlled by a control circuit 201 in accordance with the transmitting output.

The following will explain an operation to be performed when the power amplifier 102 of the above-structured transmitting apparatus 200 is used. In this case, the operation to be performed at the time of bypass control is the same as explained in the first embodiment, and the explanation will be omitted.

In the first switching circuit 103, the terminal 103a and the terminal 103b are electrically connected to each other by the control signal of the control circuit 108. Then, the signal, which is input from the input terminal 101, is output to the power amplifier 102 from the terminal 103a of the first switching circuit 103 through the terminal 103b, and amplified by the power amplifier 102. Thereafter, the amplified signal is input to the terminal 106b of the circulator 106.

At this time, in the second switching circuit 104, the terminal 104a and the terminal 104b are electrically connected to each other by the control signal of the control circuit 108. Then, the terminal 106a of the circulator 106 is terminated by the fixed resistor 111 in accordance with the circuit's characteristic impedance.

At the same time, a third switching circuit 203 is turned on by a control signal of the control circuit 201, so that drain power 109 is supplied to the power amplifier 102. Moreover, the gate voltage 202 of the power amplifier 102 is voltage controlled by the control circuit 201 such that a drain current is minimized after satisfying predetermined characteristics such as a distortion characteristic of the power amplifier 102 in accordance with transmitting power.

Here, the circulator 106 whose terminal 106a is terminated at the circuit's characteristic impedance is the same as the isolator having directivity toward the terminal 106c from the terminal 106b. In this case, the output signal of the power amplifier 102 is output to the output terminal 107 from the terminal 106c of the circulator 106.

Thus, according to the transmitting apparatus of the second embodiment, the power amplifier 102 is turned on/off in accordance with the transmitting output level, and the transmission path for transmitting signals can be switched. Then, in a case where the power amplifier 102 is used, the circulator 106 can be used as an isolator.

This eliminates the need for using the structure in which the switching circuit is connected just after the power amplifier unlike prior art, so that power loss due to the switching circuit can be reduced. Also, the gate voltage of the power amplifier 102 is variably controlled by the control circuit 201 in accordance with the transmitting output, so that power loss of the power amplifier 102 can be further reduced in accordance with the transmitting output.

### (Third embodiment)

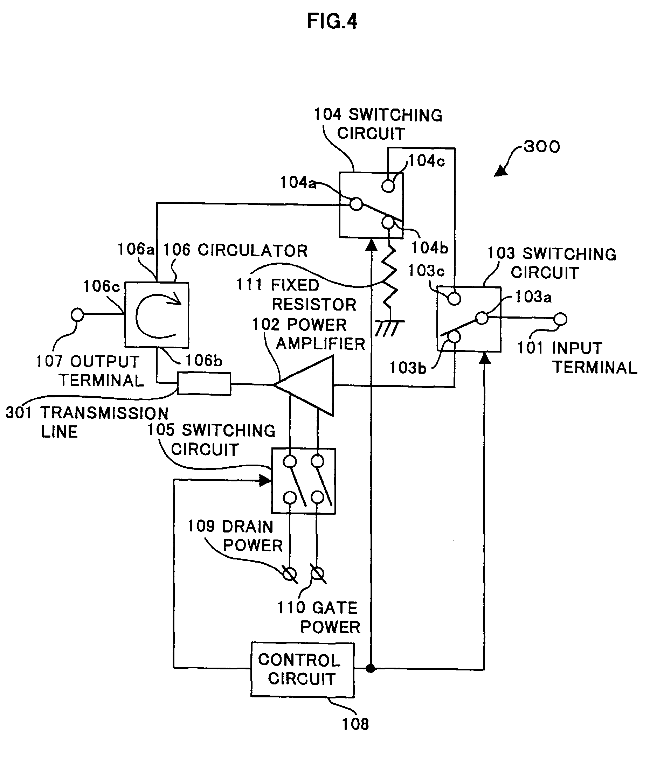

FIG. 4 is a block diagram showing the structure of a transmitting apparatus according to a third embodiment of the present invention. In this case, the same reference numerals are added to the portions common to the first embodiment of FIG. 2, and the explanation will be omitted.

The difference between a transmitting apparatus 300 of the third embodiment shown in FIG. 4 and the transmitting apparatus of the first embodiment lies in that a transmission line 301 having a coil and a capacitor combined is connected to an output side of the power amplifier 102 such that impedance, seeing from the power amplifier output connection terminal 106b of the circulator 106, is set to high in a frequency band in use when the power amplifier 102 is turned off.

The following will explain an operation to be performed when the power amplifier 102 of the above-structured transmitting apparatus 200 is used. In this case, the operation to be performed at the time of bypass control is the same as explained in the first embodiment, and the explanation will be omitted.

In the first switching circuit 103, the terminal 103a and the terminal 103b are electrically connected to each other by the control signal of the control circuit 108. Then, the signal, which is input from the input terminal 101, is output to the power amplifier 102 from the terminal 103a of the first switching circuit 103 through the terminal 103b, and amplified by the power amplifier 102. Thereafter, the amplified signal is input to the terminal 106b of the circulator 106 through the transmission line 301.

At this time, in the second switching circuit 104, the terminal 104a and the terminal 104b are electrically connected to each other by the control signal of the control circuit 108. Then, the terminal 106a of the circulator 106 is terminated by the fixed resistor 111 in accordance with the circuit's characteristic impedance.

At the same time, the third switching circuit 105 is turned on by the control signal of the control circuit 108, so that power is supplied to the power amplifier 102 from drain power 109 and gate power 110.

Here, the circulator 106 whose terminal 106a is terminated at the circuit's characteristic impedance is the same as the isolator having directivity toward the terminal 106c from the terminal 106b. In this case, the output signal of the power amplifier 102 is output to the output terminal 107 from the terminal 106c of the circulator 106.

Thus, according to the transmitting apparatus of the third embodiment, the power amplifier 102 is turned on/off in accordance with the transmitting output level, and the transmission path for transmitting signals can be switched. Then, in a case where the power amplifier 102 is used, the circulator 106 can be used as an isolator.

This eliminates the need for using the structure in which the switching circuit is connected just after the power amplifier unlike prior art, so that power loss due to the switching circuit can be reduced. Also, at a low transmission power time, the power amplifier 102 is bypassed through the bypass line so as to turn off power of the power amplifier 102, with the result that the circuit current can be reduced.

Moreover, by the provision of the transmission line 301 at the output side of the power amplifier 102, the characteristic impedance of the power amplifier 102, seeing from the power amplifier output connection terminal 106b of the circulator 106, can be set to high when the power amplifier 102 is turned off. Also, power loss of the circulator 106 caused when the power amplifier 102 is bypassed can be reduced, so that the circuit current can be decreased.

### (Fourth embodiment)

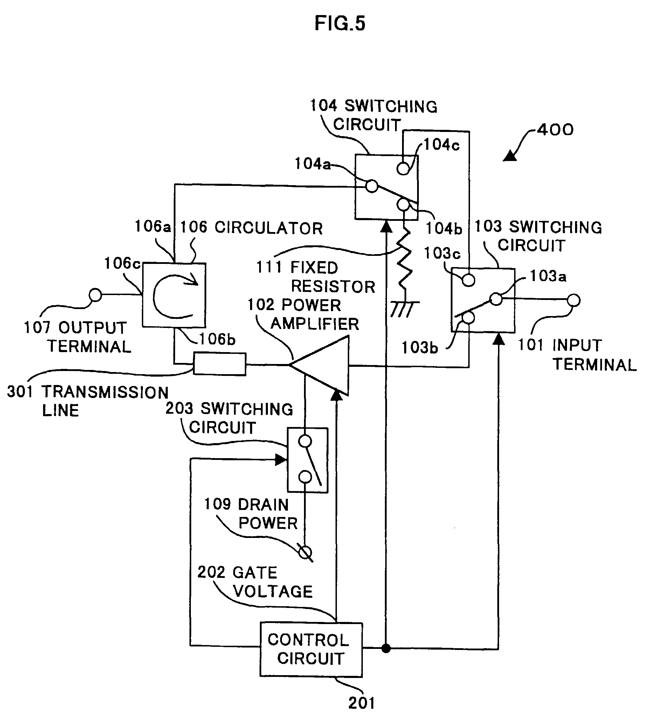

FIG. 5 is a block diagram showing the structure of a transmitting apparatus according to a fourth embodiment of the present invention. In this case, the same reference numerals are added to the portions common to the third embodiment of FIG. 4, and the explanation will be omitted. The difference between a transmitting apparatus

400 of the fourth embodiment shown in FIG. 5 and the transmitting apparatus 300 of the third embodiment lies in that the gate voltage 202 of the power amplifier 102 is controlled by the control circuit 201 in accordance with the transmitting output.

The following will explain an operation to be performed when the power amplifier 102 of the above-structured transmitting apparatus 400 is used. In this case, the operation to be performed at the time of bypass control is the same as explained in the first embodiment, and the explanation will be omitted.

In the first switching circuit 103, the terminal 103a and the terminal 103b are electrically connected to each other by the control signal of the control circuit 108. Then, the signal, which is input from the input terminal 101, is output to the power amplifier 102 from the terminal 103a of the first switching circuit 103 through the terminal 103b, and amplified by the power amplifier 102. Thereafter, the amplified signal is input to the terminal 106b of the circulator 106 through the transmission line 301.

At this time, in the second switching circuit 104, the terminal 104a and the terminal 104b are electrically connected to each other by the control signal of the control circuit 201. Then, the terminal 106a of the circulator 106 is terminated by the fixed resistor 111 in accordance with the circuit's characteristic impedance.

At the same time, the third switching circuit 203 is turned on by the control signal of the control circuit 201, so that drain power 109 is supplied to the power amplifier 102. Moreover, the gate voltage 202 of the power amplifier 102 is voltage controlled by the control circuit 201 such that a drain current is minimized after satisfying predetermined characteristics such as a distortion characteristic of the power amplifier 102 in accordance with transmitting power.

Here, the circulator 106 whose terminal 106a is terminated at the circuit's characteristic impedance is the same as the isolator having directivity toward the terminal 106c from the terminal 106b. In this case, the output signal of the power amplifier 102 is output to the output terminal 107 from the terminal 106c of the circulator 106.

Thus, according to the transmitting apparatus of the fourth embodiment, the power amplifier 102 is turned on/off in accordance with the transmitting output level, and the transmission path for transmitting signals can be switched. Then, in a case where the power amplifier 102 is used, the circulator 106 can be used as an isolator.

This eliminates the need for using the structure in which the switching circuit is connected just after the power amplifier unlike prior art, so that power loss due to the switching circuit can be reduced. Also, the gate voltage of the power amplifier 102 is variably controlled by the control circuit 201 in accordance with the transmitting output, so that power loss of the power amplifier 102 can be further reduced in accordance with the transmitting output.

Moreover, by the provision of the transmission line 301 at the output side of the power amplifier 102, the characteristic impedance of the power amplifier 102, seeing from the power amplifier output connection terminal 106b of the circulator 106, can be set to high when the power amplifier 102 is turned off. This makes it possible to reduce power loss of the circulator 106 caused when the power amplifier 102 is bypassed, with the result that the circuit current can be decreased.

### (Fifth embodiment)

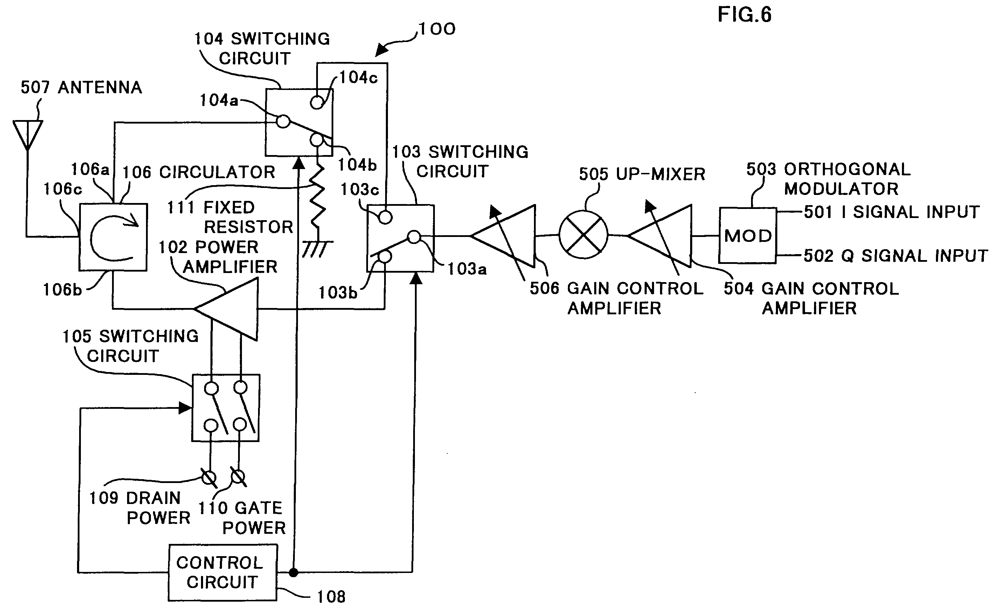

FIG. 6 is a block diagram showing the structure of a transmitter according to a fifth embodiment of the present invention.

A transmitter shown in FIG. 6 is applied to a base station apparatus in the mobile communication system or a mobile station apparatus. The transmitter of FIG. 6 comprises the transmitting apparatus 100 shown in FIG. 2. an orthogonal modulator 503, a first gain control amplifier 504, an up-mixer 505, and a second gain control amplifier 506. The orthogonal modulator 503 orthogonally modulates an I signal (I channel signal) 501. which is an input signal, and a Q signal (Q channel signal) 502. The first gain control amplifier 504 variably gain controls an output signal of the orthogonal modulator 503 in accordance with a control voltage. The up-mixer 505 frequency converts an output signal of the gain control amplifier 504. The second gain control amplifier 506 variably gain controls an output signal of the up-mixer 505 in accordance with the control voltage and outputs the gain controlled output signal to the switching circuit 103. Also, the transmitter of FIG. 6 has an antenna 507 connected to the output terminal 106c of the circulator 106.

The following will explain an operation of the above-structured transmitter. First, an operation to be performed when the power amplifier 102 is used will be explained.

The I signal 501 and the Q signal 502 are orthogonally modulated by the orthogonal modulator 503 and the gains thereof are variably controlled by the first gain control amplifier 504 in accordance with the control voltage. Then, the variably controlled outputs are frequency converted to a transmission frequency band by the up-mixer 505, and the gains thereof are variably controlled by the second gain control amplifier 506 in accordance with the control voltage. Thereafter, the variably controlled outputs are output to the first switching circuit 103.

In the first switching circuit 103, the terminal 103a and the terminal 103b are electrically connected to each other by the control signal of the control circuit 108. Then, the signal, which is input from the second gain control amplifier 506, is output to the power amplifier 102 from the terminal 103a of the first switching circuit 103 through the terminal 103b, and amplified by the power amplifier 102. Thereafter, the amplified signal is input to the terminal 106b.

At this time, in the second switching circuit 104, the terminal 104a and the terminal 104b are electrically connected to each other by the control signal of the control circuit 108. Then, the terminal 106a of the circulator 106 is terminated by the fixed resistor 111 in accordance with the circuit's characteristic impedance.

At the same time, the third switching circuit 105 is turned on by the control signal of the control circuit 108, so that power is supplied to the power amplifier 102 from drain power 109 and gate power 110.

Here, the circulator 106 whose terminal 106a is terminated at the circuit's characteristic impedance is the same as the isolator having directivity toward the terminal 106c from the terminal 106b. In this case, the output signal of the power amplifier 102 is output to the antenna 507 from the terminal 106c of the circulator 106.

Next, an operation to be performed when the power amplifier 102 is bypassed will be explained.

In the first switching circuit 103, the terminal 103a and a terminal 103c are electrically connected to each other by the control signal of the control circuit 108. Also, in the second switching circuit 104, the terminal 103c and a terminal 103a are electrically connected to each other by the control signal of the control circuit 108. Then, the signal, which is input from the second gain control amplifier 506, is input to the terminal 103c from the terminal 103a of the first switching circuit 103, and further input to the terminal 106a of the circulator 106 from the terminal 104c of the second circuit 104 through the bypass line of the terminal 104a.

At this time, in the third switching circuit 105, drain power 109 and gate power 110 are turned off, so that power of the power amplifier 102 is turned off.

When the power amplifier 102 is turned off, the circulator 106 outputs a signal in a direction of rotation of the terminal 106c from the terminal 106a.

Thus, according to the transmitter of the fifth embodiment, the power amplifier 102 is turned on/off in accordance with the transmitting output level, and the transmission path for transmitting signals can be switched. Then, in a case where the power amplifier 102 is used, the circulator 106 can be used as an isolator.

This eliminates the need for using the structure in which the switching circuit is connected just after the power amplifier unlike prior art, so that power loss due to the switching circuit can be reduced. Also, at a low transmission power time, the power amplifier 102 is bypassed through the bypass line so as to turn off power of the power amplifier 102, with the result that the circuit current can be reduced.

### (Sixth embodiment)

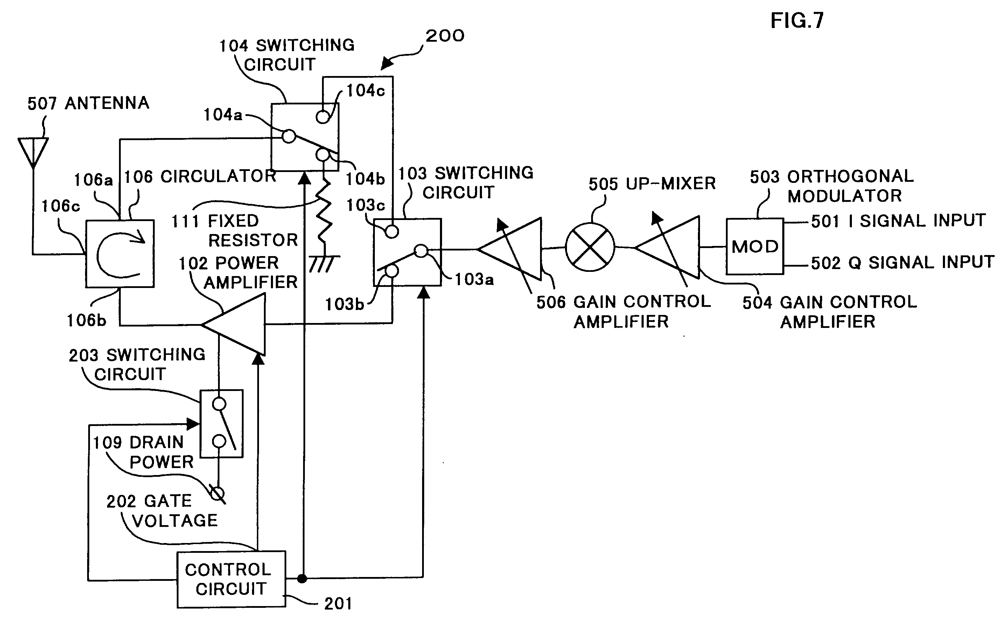

FIG. 7 is a block diagram showing the structure of a transmitter according to a sixth embodiment of the present invention. In this case, the same reference numerals are added to the portions common to the fifth embodiment of FIG. 6, and the explanation will be omitted.

A transmitter shown in FIG. 7 is applied to the base station apparatus in the mobile communication system or the mobile station apparatus. The transmitter of FIG. 7 comprises the transmitting apparatus 200 shown in FIG. 3, the orthogonal modulator 503, the first gain control amplifier 504, the up-mixer 505, and the second gain control amplifier 506. Also, the transmitter of FIG. 7 has the antenna 507 connected to the output terminal 106c of the circulator 106.

An operation to be performed when the above-structured power amplifier 102 is used will be explained. In this case, an operation to be performed when the power amplifier 102 is bypassed is the same as the case explained in the fifth embodiment, and the explanation will be omitted.

The I signal 501 and the Q signal 502 are orthogonally modulated by the orthogonal modulator 503 and the gains thereof are variably controlled by the first gain control amplifier 504 in accordance with the control voltage. Then, the variably controlled outputs are frequency converted to a transmission frequency band by the up-mixer 505, and the gains thereof are variably controlled by the second gain control amplifier 506 in accordance with the control voltage. Thereafter, the variably controlled outputs are output to the first switching circuit 103.

In the first switching circuit 103, the terminal 103a and the terminal 103b are electrically connected to each other by the control signal of the control circuit 108. Then, the signal, which is input from the second gain control amplifier 506, is output to the power amplifier 102 from the terminal 103a of the first switching circuit 103 through the terminal 103b, and amplified by the power amplifier 102. Thereafter, the amplified signal is input to the terminal 106b.

At this time, in the second switching circuit 104, the terminal 104a and the terminal 104b are electrically connected to each other by the control signal of the control circuit 201. Then, the terminal 106a of the circulator 106 is terminated by the fixed resistor 111 in accordance with the circuit's characteristic impedance.

At the same time, the third switching circuit 203 is turned on by the control signal of the control circuit 201, so that drain power 109 is supplied to the power amplifier 102. Moreover, the gate voltage 202 of the power amplifier 102 is voltage controlled by the control circuit 201 such that a drain current is minimized after satisfying predetermined characteristics such as a distortion characteristic of the power amplifier 102 in accordance with transmitting power.

Here, the circulator 106 whose terminal 106a is terminated at the circuit's characteristic impedance is the same as the isolator having directivity toward the terminal 106c from the terminal 106b. In this case, the output signal of the power amplifier 102 is output to the antenna 507 from the terminal 106c of the circulator 106.

Thus, according to the transmitter of the sixth embodiment, the power amplifier 102 is turned on/off in accordance with the transmitting output level, and the transmission path for transmitting signals can be switched. Then, in a case where the power amplifier 102 is used, the circulator 106 can be used as an isolator.

This eliminates the need for using the structure in which the switching circuit is connected just after the power amplifier unlike prior art, so that power loss due to the switching circuit can be reduced. Also, the gate voltage of the power amplifier 102 is variably controlled by the control circuit 201 in accordance with the transmitting output, so that power loss of the power amplifier 102 can be further reduced in accordance with the transmitting output.

### (Seventh embodiment)

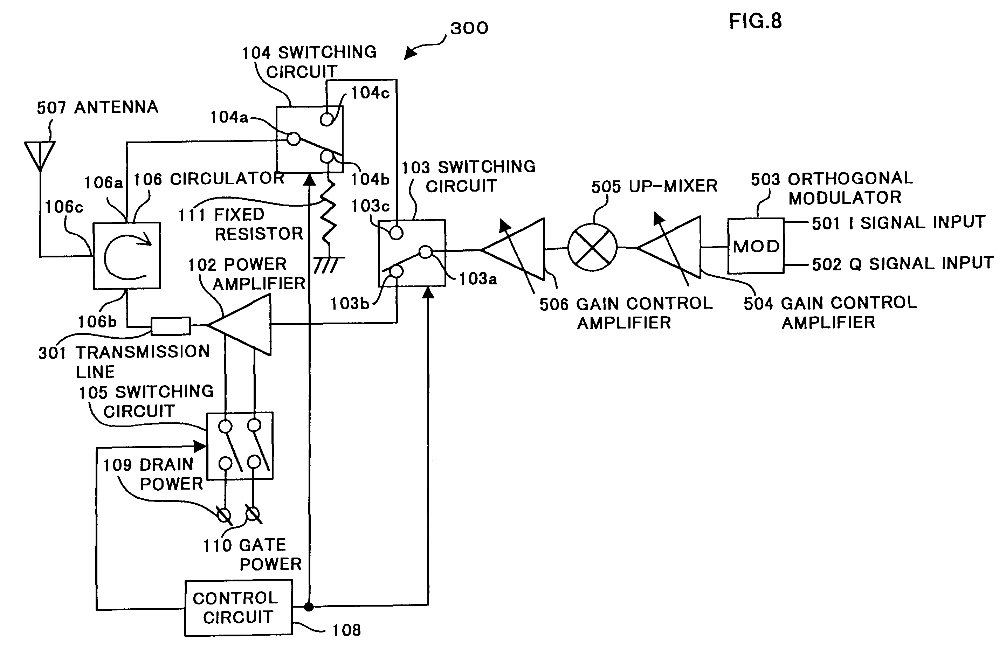

FIG. 8 is a block diagram showing the structure of a transmitter according to a seventh embodiment of the present invention. In this case, the same reference numerals are added to the portions common to the fifth embodiment of FIG. 6, and the explanation will be omitted.

A transmitter shown in FIG. 8 is applied to the base station apparatus in the mobile communication system or the mobile station apparatus. The transmitter of FIG. 8 comprises the transmitting apparatus 300 shown in FIG. 4, the orthogonal modulator 503, the first gain control amplifier 504, the up-mixer 505, and the second gain control amplifier 506. Also, the transmitter of FIG. 8 has the antenna 507 connected to the output terminal 106c of the circulator 106.

An operation to be performed when the above-structured power amplifier 102 is used will be explained. In this case, an operation to be performed when the power amplifier 102 is bypassed is the same as explained in the fifth embodiment, and the explanation will be omitted.

The I signal 501 and the Q signal 502 are orthogonally modulated by the orthogonal modulator 503 and the gains thereof are variably controlled by the first gain control amplifier 504 in accordance with the control voltage. Then, the variably controlled outputs are frequency converted to a transmission frequency band by the up-mixer 505, and the gains thereof are variably controlled by the second gain control amplifier 506 in accordance with the control voltage. Thereafter, the variably controlled outputs are output to the first switching circuit 103.

In the first switching circuit 103, the terminal 103a and the terminal 103b are electrically connected to each other by the control signal of the control circuit 108. Then, the signal, which is input from the second gain control amplifier 506, is output to the power amplifier 102 from the terminal 103a of the first switching circuit 103 through the terminal 103b, and amplified by the power amplifier 102. Thereafter, the amplified signal is input to the terminal 106b of the circulator 106 through the transmission line 301.

At this time, in the second switching circuit 104, the terminal 104a and the terminal 104b are electrically connected to each other by the control signal of the control circuit 108. Then, the terminal 106a of the circulator 106 is terminated by the fixed resistor 111 in accordance with the circuit's characteristic impedance.

At the same time, the third switching circuit 105 is turned on by the control signal of the control circuit 108, so that power is supplied to the power amplifier 102 from drain power 109 and gate power 110.

Here, the circulator 106 whose terminal 106a is terminated at the circuit's characteristic impedance is the same as the isolator having directivity toward the terminal 106c from the terminal 106b. In this case, the output signal of the power amplifier 102 is output to the antenna 507 from the terminal 106c of the circulator 106.

Thus, according to the transmitter of the seventh embodiment, the power amplifier 102 is turned on/off in accordance with the transmitting output level, and the transmission path for transmitting signals can be switched. Then, in a case where the power amplifier 102 is used, the circulator 106 can be used as an isolator.

This eliminates the need for using the structure in which the switching circuit is connected just after the power amplifier unlike prior art, so that power loss due to the switching circuit can be reduced. Also, at a low transmission power time, the power amplifier 102 is bypassed through the bypass line so as to turn off power of the power amplifier 102, with the result that the circuit current can be reduced.

Moreover, by the provision of the transmission line 301 at the output side of the power amplifier 102, the characteristic impedance of the power amplifier 102, seeing from the power amplifier output connection terminal 106b of the circulator 106, can be set to high when the power amplifier 102 is turned off. Also, power loss of the circulator 106 caused when the power amplifier 102 is bypassed can be reduced, so that the circuit current can be decreased.

### (Eighth embodiment)

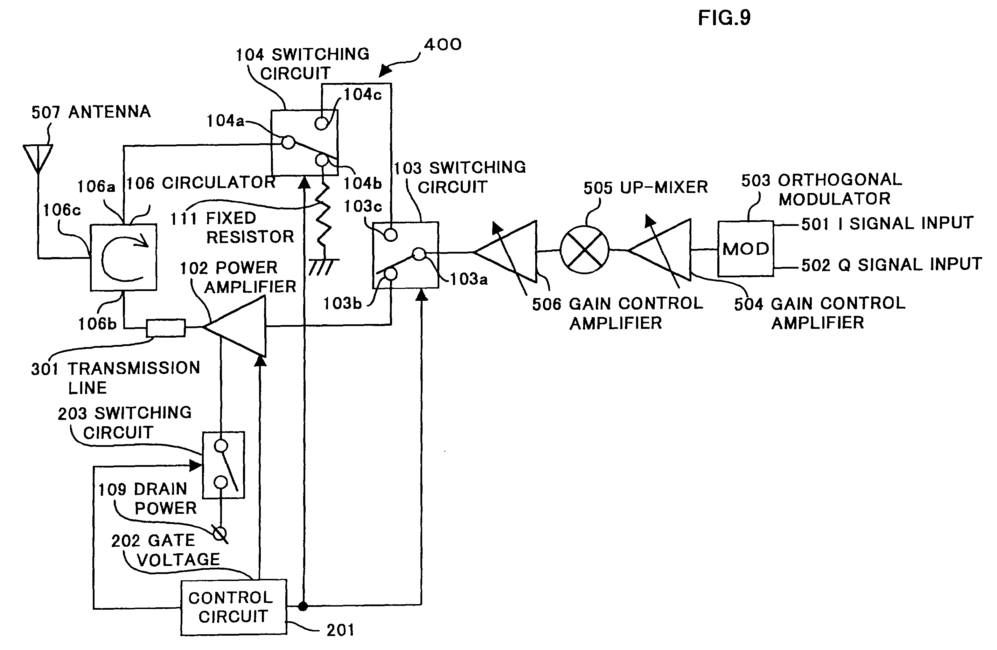

FIG. 9 is a block diagram showing the structure of a transmitter according to an eighth embodiment of the present invention. In this case, the same reference numerals are added to the portions common to the seventh embodiment of FIG. 8, and the explanation will be omitted.

A transmitter shown in FIG. 9 is applied to the base station apparatus in the mobile communication system or the mobile station apparatus. The transmitter of FIG. 9 comprises the transmitting apparatus 400 shown in FIG. 5, the orthogonal modulator 503, the first gain control amplifier 504, the up-mixer 505, and the second gain control amplifier 506. Also, the transmitter of FIG. 8 has the antenna 507 connected to the output terminal 106c of the circulator 106.

An operation to be performed when the above-structured power amplifier 102 is used will be explained. In this case, an operation to be performed when the power amplifier 102 is bypassed is the same as explained in the fifth embodiment, and the explanation will be omitted.

The I signal 501 and the Q signal 502 are orthogonally modulated by the orthogonal modulator 503 and the gains thereof are variably controlled by the first gain control amplifier 504 in accordance with the control voltage. Then, the variably controlled outputs are frequency converted to a transmission frequency band by the up-mixer 505, and the gains thereof are variably controlled by the second gain control amplifier 506 in accordance with the control voltage. Thereafter, the variably controlled outputs are output to the first switching circuit 103.

In the first switching circuit 103, the terminal 103a and the terminal 103b are electrically connected to each other by the control signal of the control circuit 108. Then, the signal, which is input from the second gain control amplifier 506, is output to the power amplifier 102 from the terminal 103a of the first switching circuit 103 through the terminal 103b, and amplified by the power amplifier 102. Thereafter, the amplified signal is input to the terminal 106b of the circulator 106 through the transmission line 301.

At this time, in the second switching circuit 104, the terminal 104a and the terminal 104b are electrically connected to each other by the control signal of the control circuit 201. Then, the terminal 106a of the circulator 106 is terminated by the fixed resistor 111 in accordance with the circuit's characteristic impedance.

At the same time, the third switching circuit 203 is turned on by the control signal of the control circuit 201, so that drain power 109 is supplied to the power amplifier 102. Moreover, the gate voltage 202 of the power amplifier 102 is voltage controlled by the control circuit 201 such that a drain current is minimized after satisfying predetermined characteristics such as a distortion characteristic of the power amplifier 102 in accordance with transmitting power.

Here, the circulator 106 whose terminal 106a is terminated at the circuit's characteristic impedance is the same as the isolator having directivity toward the terminal 106c from the terminal 106b. In this case, the output signal of the power amplifier 102 is output to the antenna 507 from the terminal 106c of the circulator 106.

Thus, according to the transmitter of the eighth embodiment, the power amplifier 102 is turned on/off in accordance with the transmitting output level, and the transmission path for transmitting signals can be switched. Then, in a case where the power amplifier 102 is used, the circulator 106 can be used as an isolator.

This eliminates the need for using the structure in which the switching circuit is connected just after the power amplifier unlike prior art, so that power loss due to the switching circuit can be reduced. Also, the gate voltage of the power amplifier 102 is variably controlled by the control circuit 201 in accordance with the transmitting output, so that power loss of the power amplifier 102 can be further reduced in accordance with the transmitting output.

Moreover, by the provision of the transmission line 301 at the output side of the power amplifier 102, the characteristic impedance of the power amplifier 102, seeing from the power amplifier output connection terminal 106b of the circulator 106, can be set to high when the power amplifier 102 is turned off. Also, power loss of the circulator 106 caused when the power amplifier 102 is bypassed can be reduced, so that the circuit current can be decreased.

As explained above, according to the present invention, the bypass control of the power amplifier can be carried out without increasing the current of the circuit, and high efficiency of the transmitting apparatus can be realized.

The present invention is not limited to the above described embodiments, and various variations and modifications may be possible without departing from the scope of the present invention.

This application is based on the Japanese Patent Application No. HEI 10-247225 filed on September 1, 1998, entire content of which is expressly incorporated by reference herein.

## Claims

1. A transmitting apparatus for amplifying a signal input from an input terminal or outputting said signal from an output terminal directly, said transmitting apparatus comprising:
amplifying means (102) for amplifying said signal;
a circulator (106) for connecting said amplifying means and said output terminal to each other;
path selecting means (103,104,108) for connecting said input terminal and said amplifying means to each other at an amplifying time and for connecting said circulator and a fixed resistor to each other.

2. The transmitting apparatus according to claim 1, wherein said path selecting means connects said input terminal and said circulator to each other at a non-amplifying time.

3. The transmitting apparatus according to claim 2, wherein said path selecting means comprises first switching means (103) and second switching means (104) each having two moving contacts and one fixed contact and connecting to each other at one moving contact, wherein said first switching means is connected to said input terminal at said fixed contact and is connected to amplifying means at the other moving contact, and said second switching means is connected to said circulator at said fixed contact and is connected to a fixed resistor at the other moving contact.

4. The transmitting apparatus according to claim 2, wherein said path selecting means comprises third switching means (105) for switching on/off power of amplifying means, wherein power of said amplifying means is switched off at a non-amplifying time.

5. The transmitting apparatus according to claim 1, further comprising a transmission line (301) between said amplifying means and said circulator.

6. A mobile station apparatus having a transmitting apparatus, said transmitting apparatus comprising:
amplifying means for amplifying said signal;
a circulator for connecting said amplifying means and said output terminal to each other;
path selecting means for connecting said input terminal and said amplifying means to each other at an amplifying time and for connecting said circulator and a fixed resistor to each other.

7. A base station apparatus having a transmitting apparatus, said transmitting apparatus comprising:
amplifying means for amplifying said signal;
a circulator for connecting said amplifying means and said output terminal to each other;
path selecting means for connecting said input terminal and said amplifying means to each other at an amplifying time and for connecting said circulator and a fixed resistor to each other.
